(19) Europäisches Patentamt
European Patent Office
Office européen des brevets

(11) **EP 0 744 828 B1**

(12) **EUROPÄISCHE PATENTSCHRIFT**

(45) Veröffentlichungstag und Bekanntmachung des Hinweises auf die Patenterteilung:
**06.08.2003   Patentblatt 2003/32**

(51) Int Cl.$^7$: **H03F 3/08**, H03G 1/00

(21) Anmeldenummer: **96106984.6**

(22) Anmeldetag: **03.05.1996**

(54) **Transimpedanzverstärkerschaltung**

Transimpedance amplifier circuit

Circuit amplificateur à transimpédance

(84) Benannte Vertragsstaaten:
**DE FR GB IT**

(30) Priorität: **22.05.1995   DE 19518734**

(43) Veröffentlichungstag der Anmeldung:
**27.11.1996   Patentblatt 1996/48**

(73) Patentinhaber: **Infineon Technologies AG**
**81669 München (DE)**

(72) Erfinder: **Herrle, Jürgen, Dipl.-Ing.**
**85051 Ingolstadt (DE)**

(74) Vertreter: **Charles, Glyndwr**
**Reinhard-Skuhra-Weise & Partner,**
**Patentanwälte,**
**Friedrichstrasse 31**
**80801 München (DE)**

(56) Entgegenhaltungen:
**DE-A- 3 607 688        DE-A- 4 212 934**
**DE-C- 3 408 284**

EP 0 744 828 B1

**Beschreibung**

Die Erfindung betrifft eine Transimpedanzverstärkerschaltung mit einem invertierenden Verstärker, dessen Eingang durch einen Eingangsstrom gespeist wird und dessen Ausgang eine Ausgangsspannung führt, und mit einem Kopplungsglied, das zwischen Eingang und Ausgang des invertierenden Verstärkers geschaltet ist.

Eine derartige Transimpedanzverstärkerschaltung ist beispielsweise aus U. Tietze, Ch. Schenk, Electronic Circuits-Design and Applications, Berlin, Heidelberg 1991, Seite 97 bekannt, wobei als Kopplungsglied ein ohmscher Widerstand vorgesehen ist. Transimpedanzverstärker setzen einen Eingangsstrom in eine proportionale Spannung um und werden daher in der Regel zur Verstärkung der von Fotodioden erzeugten Ströme verwendet. Dieser Strom kann zum einen sehr klein - z.B. 1μA- oder auch im Vergleich dazu sehr groß -beispielsweise 1mA- sein. Daraus ergeben sich Dimensionierungsprobleme, die insbesondere auf den bei der bekannten Lösung in der Rückkopplungsschleife verwendeten ohmschen Widerstand zurückzuführen sind.

Der Widerstand muß klein sein, um bei großen Strömen eine Übersteuerung des Transimpedanzverstärkers zu vermeiden. Damit steigt aber das Eingangsrauschen des Transimpedanzverstärkers, da kleinere Widerstände größere thermische Rauschströme erzeugen. Kleinere Widerstände bewirken auch eine Reduzierung der Empfindlichkeit, so daß kleine Eingangsströme im Rauschen untergehen. Damit wird aber insgesamt der Dynamikbereich des Transimpedanzverstärkers stark eingeschränkt.

Transimpedanzverstärker mit großem Dynamikbereich weisen allerdings eine hohe Grundverstärkung auf, um auch bei sehr kleinen Eingangsströmen ein ausreichend großes Ausgangssignal erzeugen zu können. Dies führt jedoch bei großen Eingangsströmen zu einer erhöhten Schwingneigung.

Aufgabe der Erfindung ist es daher, eine Transimpedanzverstärkerschaltung mit größerem Dynamikbereich und geringerer Schwingneigung anzugeben.

Die Aufgabe wird bei einer Transimpedanzverstärkerschaltung der eingangs genannten Art durch die kennzeichnenden Merkmale des Anspruchs 1 gelöst. Weiterbildungen der Erfindung sind Gegenstand von Unteransprüchen.

Die erfindungsgemäße Transimpedanzverstärkerschaltung paßt zur Vergrößerung des Dynamikbereichs die Rückkopplungsimpedanz entsprechend der Größe des Eingangssignals an. Dies geschieht beispielsweise mit Hilfe von Diodenstrecken, die durch einen Gleichstrom, der proportional dem Gleichanteil des Eingangsstroms ist, vorgespannt werden und so für die nötige Änderung des dynamischen Widerstandes sorgen. Die Nichtlinearität der Dioden wird durch den nachgeschalteten Differenzverstärker kompensiert, so daß im gesamten Widerstandsbereich keine Linearitätsfehler auftreten.

Die Unterdrückung der Schwingneigung erfolgt dadurch, daß auch die Steilheit des Verstärkers entsprechend der Größe des Eingangsstromes angepaßt wird. Indem bei einer Weiterbildung der Erfindung zur Einstellung der Steilheit das bereits zur Verfügung stehende Signal zur Einstellung des Rückkoppelwiderstandes verwendet wird, ist der zusätzliche Schaltungsaufwand sehr gering.

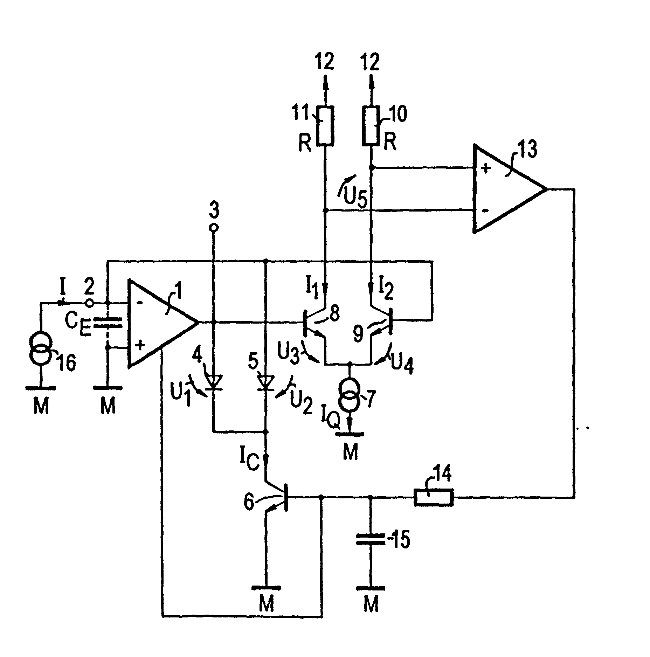

Die Erfindung wird nachfolgend anhand des in der einzigen Figur der Zeichnung dargestellten Ausführungsbeispiels näher erläutert.

Bei dem in der Zeichnung gezeigten Ausführungsbeispiel ist ein invertierender Spannungsverstärker vorgesehen, der beispielsweise durch einen Operationsverstärker 1 gebildet wird. An den nichtinvertierenden Eingang des Operationsverstärkers 1 ist dabei ein Bezugspotential M angeschlossen. Dabei bilden sein invertierender Eingang den Eingang 2 des invertierenden Spannungsverstärkers und sein Ausgang den Ausgang des Spannungsverstärkers. Der Eingang 2 ist mit einem Anschluß einer Stromquelle 16 verbunden, deren anderer Anschluß an dem Bezugspotential M liegt, wobei er mit einem Strom I gespeist wird.

Zwischen Eingang 2 und Ausgang 3 des invertierenden Spannungsverstärkers 1 sind als Kopplungsglied zwei Dioden 4 und 5 antiseriell geschaltet und zwar beispielsweise derart, daß die Anoden beider Dioden 4 und 5 mit dem Eingang 2 bzw. dem Ausgang 3 verbunden sind und die beiden Katoden miteinander verschaltet sind. Die beiden miteinander gekoppelten Katoden der Dioden 4 und 5 wiederum sind mit dem Kollektor eines npn-Transistors 6 verbunden, dessen Emitteranschluß an das Bezugspotential M angeschlossen ist. Anstelle der Anordnung mit den Dioden 4 und 5 sowie dem Transistor 6 können in gleicher Weise auch andere steuerbare Impedanzen, wie beispielsweise steuerbare Widerstände oder steuerbare Tiefpässe, die beispielsweise aus einem steuerbaren Widerstand im Rückkopplungszweig und einer eingangsseitig parallel liegenden Kapazität bestehen, als Kopplungsglied verwendet werden.

Der Basis des Transistors 6 ist ein Tiefpaß vorangestellt, der aus einem zwischen das Bezugspotential M und die Basis des Transistors 6 geschalteten Kondensator 15 sowie aus einem einerseits an die Basis des Transistors 6 und andererseits an den Ausgang eines Operationsverstärkers 13 angeschlossenen Widerstand 14 besteht.

Der Operationsverstärker 13 bildet die Ausgangsstufe eines Differenzverstärkers, dessen Eingangsstufe durch ein aus einer Stromquelle 7 gespeistes, emittergekoppeltes npn-Transistorpaar 8, 9 sowie aus durch in die Kollektorkreise der Transistoren 8 und 9 geschaltete Widerstände gebildet wird. Im einzelnen sind die gekoppelten Emittertransistoren 8 und 9 über die Stromquelle 7 mit dem Bezugspotential M verbunden. Die Kollektoren der beiden Transistoren 8 und 9 sind über jeweils einen Widerstand 11 bzw. 10 an ein positives Versorgungspotential 12 angeschlossen. Darüber hinaus ist der Kollektor des Transistors 8 mit dem invertierenden Eingang und der Kollektor des Transistors 9 mit dem nichtinvertierenden Eingang des Operationsverstärkers 13 verschaltet. Die Eingänge des Differenzverstärkers darstellenden Basen der Transistoren 8 und 9 sind mit Ein- und Ausgang 2 und 3 des invertierenden Spannungsverstärkers 1 derart verbunden, daß die Basis des Transistors 8 mit dem Ausgang 3 und die Basis des Transistors 9 mit dem Eingang 2 gekoppelt ist.

Schließlich ist die Steilheit des invertierenden Spannungsverstärkers 1 durch ein entsprechendes Steuersignal einstellbar. Dazu wird beispielsweise mindestens eine Stromquelle einer Differenzverstärkerstufe innerhalb des invertierenden Spannungsverstärkers 1 durch dieses Steuersignal gesteuert. Als Steuersignal wird vorzugsweise das Ausgangssignal des Tiefpasses bestehend aus dem Widerstand 14 und dem Kondensator 15 vorgesehen.

Nachdem zuvor der prinzipielle Aufbau eines erfindungsgemäßen Impedanzverstärkers erläutert worden ist, soll im folgenden näher auf dessen Funktionsweise eingegangen werden.

Der von der Stromquelle 16 -beispielsweise einer mit einem Glasfaserkabel gekoppelten Fotodiodeerzeugte Strom I setzt sich additiv aus einem Gleichanteil $I_{DC}$ und einem Wechselstromanteil $I_{AC}$ zusammen, wobei die Amplitude des Wechselstromanteils $I_{AC}$ immer kleiner oder gleich dem Gleichstromanteil $I_{DC}$ ist. Das Verhalten der Dioden 4 und 5 kann durch eine Exponentialfunktion derart beschrieben werden, daß die Spannung über der Diode gleich dem Produkt ist aus der Temperaturspannung $U_T$ und dem Logarithmus aus dem Verhältnis von dem sie durchfließenden Strom zu dem Sättigungsstrom $I_S$. Da die Diode 4 durch einen Strom durchflossen wird, der gleich der Differenz zwischen dem Kollektorstrom $I_C$ des Transistors 6 und den Gleichstromanteil $I_{DC}$ des Stromes I ist und da der Strom durch die Diode 5 gleich dem Gleichstromanteil $I_{DC}$ des Stromes I ist, ergibt sich:

$$U_1 = U_T \cdot \ln \frac{I_C - I_{DC}}{I_S}$$

$$U_2 = U_T \cdot \ln \frac{I_{DC}}{I_S}.$$

Die Regelung über den Differenzverstärker und den nachgeschalteten Tiefpaß erfolgt derart, daß die Spannung $U_1$ gleich der Spannung $U_2$ wird und damit der Kollektorstrom $I_C$ des Transistors 6 doppelt so groß wird wie der Gleichanteil $I_{DC}$ des Stroms I. Somit steht die Gleichstromeinstellung der Transimpedanzverstärkerschaltung fest.

Hinsichtlich des Wechselstromanteils $I_{AC}$ gilt:

$$U_1 = U_T \cdot \ln \frac{I_{DC} - I_{AC}}{I_S}$$

$$U_2 = U_T \cdot \ln \frac{I_{DC} + I_{AC}}{I_S}$$

Die Basis-Emitter-Spannungen $U_3$ und $U_4$ der Transistoren 8 und 9 ergeben sich aus den jeweils zugehörigen Kollektorströmen $I_1$ und $I_2$ wie folgt:

$$U_3 = U_T \cdot \ln \frac{I_1}{I_S}$$

$$U_4 = U_T \cdot \ln \frac{I_2}{I_S}.$$

Außerdem gilt, daß die Differenz zwischen den Spannungen $U_3$ und $U_4$ gleich der Differenz der Spannungen $U_1$ und $U_2$ ist, wobei die Summe der Ströme $I_1$ und $I_2$ gleich dem Strom $I_Q$ sowie die differenzielle Eingangsspannung $U_5$ des Operationsverstärkers 13 gleich der mit dem Widerstandswert R der beiden Widerstände 10 und 11 multiplizierten Differenz zwischen den Strömen $I_2$ und $I_1$ ist. Daraus folgt:

$$U_1 - U_2 = U_T \cdot \ln \frac{I_C \cdot U_{AC}}{I_C \cdot R + U_{AC}}.$$

Daraus ergibt sich für die differenzielle Spannung:

$$U_5 = I_C \cdot R \cdot \frac{I_{AC}}{I_{DC}}.$$

Danach ist die differenzielle Spannung $U_5$ linear vom Wechselstromanteil $I_{AC}$ des Stromes I abhängig. Da der Betrag der Amplitude des Wechselstromanteils $I_{AC}$ proportional ist zum Gleichstromanteil $I_{DC}$ des Stroms I, ist die Amplitude der differenziellen Spannung $U_5$ unabhängig von der Amplitude des Wechselstromanteils $I_{AC}$. Daraus folgt wiederum daß der Transimpedanzwiderstand $R_T$ proportional ist zum Kehrwert der Amplitude des Wechselstromanteils $I_{AC}$.

Der Transimpedanzwiderstand $R_T$ ergibt sich aufgrund der Serienschaltung von zwei Dioden zu $R_T = 2 \cdot \frac{U_T}{I_{DC}}$. Aus dem Rauschstrom (Schrotrauschen) einer Diode mit $I_R{}^2 = 2 \cdot I_{DC} \cdot q \cdot \Delta f$ und dem Transimpedanzwiderstand $R_T$ ergibt sich eine entsprechende Rauschspannung an den beiden in Serie geschalteten Dioden 4 und 5 zu

$$U_R{}^2 = 4 \cdot k \cdot T \cdot \Delta f \cdot \frac{U_T}{I_{DC}}.$$

Damit errechnet sich der äquivalente Eingangsrauschstrom $I_R{}^2$ zu

$$I_R{}^2 = \frac{2 \cdot k \cdot T \cdot \Delta f}{R_T}.$$

Demgegenüber beträgt der äquivalente Rauschstrom bei einer Beschaltung mit einem ohmschen Widerstand als Transimpedanzwiderstand gleichen Wertes

$$I_R{}^2 = \frac{4 \cdot k \cdot T \cdot \Delta f}{R_T}.$$

Der Vergleich zeigt, daß das Rauschstromquadrat bei gleich großem Transimpedanzwiderstand $R_T$ nur halb so groß ist.

Die Grenzfrequenz $f_g$ des Transimpedanzverstärkers ist eine Funktion seiner Verstärkung v und damit der Steilheit des Spannungsverstärkers 1. Die Grenzfrequenz ergibt sich zu

$$f_g = \frac{1}{2\tau R_T C_E},$$

wobei $R_T$ wiederum der Transimpedanzwiderstand und $C_E$ die Eingangskapazität des Spannungsverstärkers 1 ist. Damit wird auch die Grenzfrequenz in Abhängigkeit des Eingangsstromes I verändert.

**Patentansprüche**

1. Transimpedanzverstärkerschaltung mit einem invertierenden Verstärker (1), dessen Eingang (2) durch einen Eingangsstrom (I) gespeist wird und dessen Ausgang (3) eine Ausgangsspannung führt, und mit einem Kopplungsglied, das zwischen Eingang (2) und Ausgang (3) des invertierenden Verstärkers (1) geschaltet ist, wobei die Impedanz des Kopplungsglieds (4, 5, 6) steuerbar ist, **dadurch gekennzeichnet, daß** an Eingang (2) und Ausgang (3) des invertierenden Verstärkers (1) je einer der beiden Eingänge eines Differenzverstärkers (7, 8, 9, 10, 11, 13) angeschlossen ist, daß ein dem Differenzverstärker (7, 8, 9, 10, 11, 13) nachgeschalteter Tiefpaß (14, 15) an seinem Ausgang das Ansteuersignal für das Kopplungsglied (4, 5, 6) bereitstellt und daß die Steilheit des invertierenden Verstärkers (1) in Abhängigkeit vom Eingangsstrom (I) eingestellt wird.

2. Transimpedanzverstärkerschaltung nach Anspruch 1, **dadurch gekennzeichnet, daß** das Ansteuersignal für das Kopplungsglied (4, 5, 6) auch zur Einstellung der Steilheit des invertierenden Verstärkers (1) vorgesehen ist.

3. Transimpedanzverstärkerschaltung nach Anspruch 1 oder 2, **gekennzeichnet durch** ein Kopplungsglied mit zwei Dioden (4, 5), die antiseriell zueinander zwischen Eingang (2) und Ausgang (3) des invertierenden Verstärkers (1) geschaltet sind und deren gemeinsamer Knotenpunkt über die Laststrecke eines Transistors (6) mit einem Bezugspotential (M) verbunden ist, wobei der Steueranschluß des Transistors (6) mit dem Ausgang des Tiefpasses (14, 15) gekoppelt ist.

4. Transimpedanzverstärker nach einem der Ansprüche 1 bis 4, **dadurch gekennzeichnet, daß** dem invertierenden Verstärker eingangsseitig eine Kapazität ($C_E$) parallel geschaltet ist.

**Claims**

1. Transimpedance amplifier circuit having an inverting amplifier (1), whose input (2) is fed by an input current (I) and whose output (3) carries an output voltage, and having a coupling element connected between the input (2) and the output (3) of the inverting amplifier (1), the impedance of the coupling element (4, 5, 6) being controllable, **characterized in that** in each case one of the two inputs of a differential amplifier (7, 8, 9, 10, 11, 13) is connected to input (2) and output (3) of the inverting amplifier (1), **in that** a low-pass filter (14, 15) connected downstream of the differential amplifier (7, 8, 9, 10, 11, 13) provides, at its output, the drive signal for the coupling element (4, 5, 6), and **in that** the transconductance of the inverting amplifier (1) is set in a manner dependent on the input current (I).

2. Transimpedance amplifier circuit according to Claim 1, **characterized in that** the drive signal for the coupling element (4, 5, 6) is also provided for setting the transconductance of the inverting amplifier (1).

3. Transimpedance amplifier circuit according to Claim 1 or 2, **characterized by** a coupling element with two diodes (4, 5), which are reverse-connected in series with one another between input (2) and output (3) of the inverting amplifier (1) and whose common node is connected to a reference-earth potential (M) via the load path of a transistor (6), the control terminal of the transistor (6) being coupled to the output of the low-pass filter (14, 15).

4. Transimpedance amplifier according to one of Claims 1 to 4, **characterized in that** a capacitance ($C_E$) is connected in parallel with the inverting amplifier on the input side.

## Revendications

1. Circuit amplificateur de transimpédance avec un amplificateur inverseur (1), dont l'entrée (2) est alimentée par un courant d'entrée (I) et dont la sortie (3) délivre une tension de sortie, et avec un élément de couplage, qui est connecté entre l'entrée (2) et la sortie (3) de l'amplificateur inverseur (1), dans lequel l'impédance de l'élément de couplage (4, 5, 6) est réglable, **caractérisé en ce qu'**à l'entrée (2) et à la sortie (3) de l'amplificateur inverseur (1) est connectée à chaque fois l'une des deux entrées d'un amplificateur différentiel (7, 8, 9, 10, 11, 13), **en ce qu'**un filtre passe-bas (14, 15), connecté en aval de l'amplificateur différentiel (7, 8, 9, 10, 11, 13) délivre à sa sortie le signal de commande pour l'élément de couplage (4, 5, 6) et **en ce que** le taux de variation de l'amplificateur inverseur (1) est réglée en fonction du courant d'entrée (I).

2. Circuit amplificateur de transimpédance selon la revendication 1, **caractérisé en ce que** le signal de commande pour l'élément de couplage (4, 5, 6) est prévu également pour le réglage du taux de variation de l'amplificateur inverseur (1).

3. Circuit amplificateur de transimpédance selon la revendication 1 ou 2, **caractérisé par** un élément de couplage avec deux diodes (4, 5), qui sont connectées à l'inverse d'un branchement en série l'une par rapport à l'autre entre l'entrée (2) et la sortie (3) de l'amplificateur inverseur (1) et dont le point nodal commun est relié par la section de charge d'un transistor (6) à un potentiel de référence (M), la borne de commande du transistor (6) étant couplée à la sortie du filtre passe-bas (14, 15).

4. Circuit amplificateur de transimpédance selon l'une des revendications 1 à 3, **caractérisé en ce que** du côté de l'entrée, une capacité ($C_E$) est connectée en parallèle à l'amplificateur inverseur.